# EUROPEAN PATENT APPLICATION

(11) **EP 0 722 219 A2**
(43) Date of publication of application: **17.07.1996**
(21) Application number: 96100495.9
(22) Date of filing: 15.01.1996
(51) Int. Cl.: H03K 3/037, H03K 3/3562

(54) **High-speed flip-flop circuit**

(30) Priority: 13.01.1995 JP 20951/95
(71) Applicant: NEC CORPORATION, Tokyo (JP)
(72) Inventor: Oyamada, Makoto, c/o Nec Corporation, Tokyo (JP)
(74) Representative: Betten & Resch

(57) **Abstract**

A circuit comprises a master loop (103-105) and a slave loop (108-110), wherein the data and the inverted data retained in the master loop are respectively transferred to the output terminal (111) and the inverted output terminal (112) of the slave loop through the bi-directional transfer gates (106, 107) or the clocked inverters (705, 706) each concurrently switching from a conduction state to a high-impedance state and vice versa.

## Description

### 1. Field of the invention

The present invention generally relates to a high-speed logic circuit, and in particular to an arrangement of a static type master-slave flip-flop circuit for use in a high-speed microprocessor, a local-area network (LAN), and the likes.

### 2. Description of the Related Art

Recently, high-speed microprocessors have been increasingly required to meet the rapid progress of data processing technology. In the field of EWS (engineering work station), for instance, RISC (reduced instruction set computing) processors are usually operated at clock signal frequencies of 133-300 MHz and the speed will increase more and more in future.

The increased speed of a processor results in high-performance computer networks and LANs, which in turn require switching LSIs and controllers operating at high clock signal frequencies. As known well, flip-flop circuits are indispensable to logic circuits like these. Especially, static type master-slave flip-flop circuits are considered to be elementary circuits indispensable to high-speed and stable logic circuits.

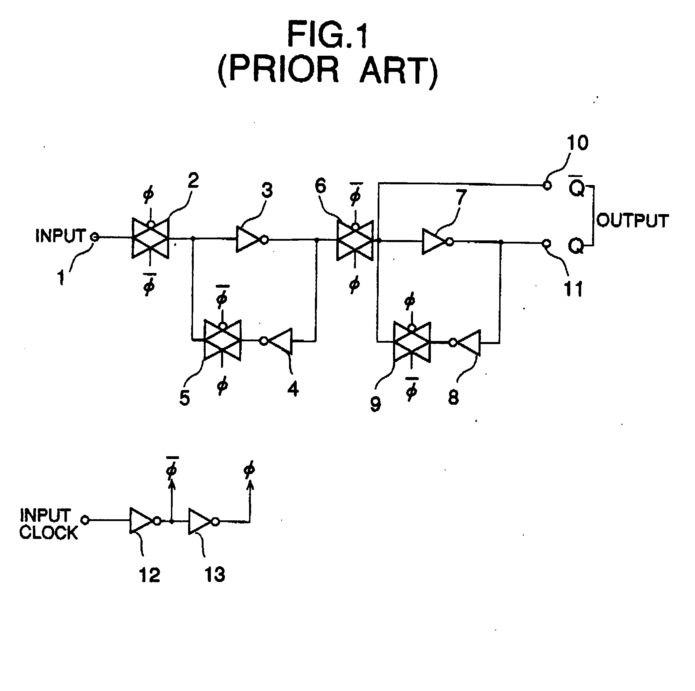

A conventional master-slave flip-flop circuit suitable for high-speed operation is disclosed in Japanese Patent Unexamined Publication No. 63-211914. Referring to Fig. 1, the circuit has a master loop and a slave loop which are connected in series. The master loop is comprised of inverters 3, 4 and a bi-directional transfer gate 5, which is connected to an input terminal 1 through a bi-directional transfer gate 2. The slave loop is comprised of inverters 7, 8 and a bi-directional transfer gate 9, which is connected to the master loop through a bi-directional transfer gate 6. An inverted output terminal 10 is connected to the bi-directional transfer gate 6 and an output terminal 11 to the output of the inverter 7. The clock signal and the inverted clock signal are respectively generated by inverters 12 and 13 connected in series.

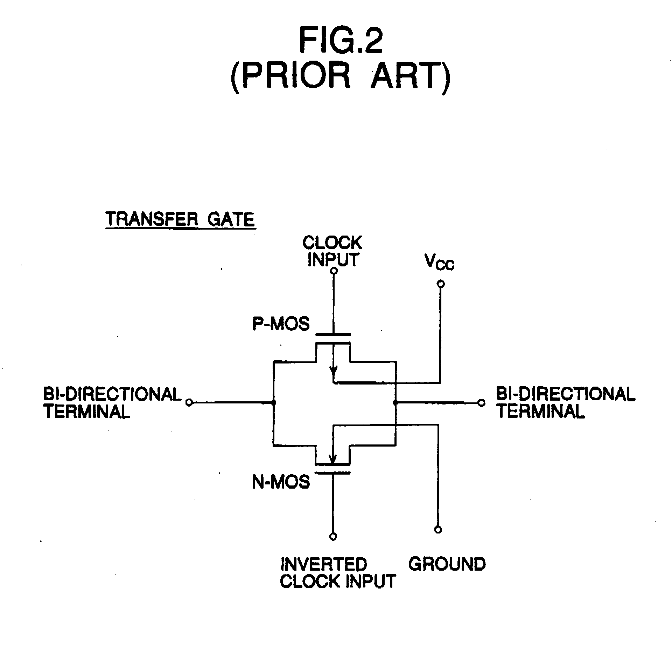

Referring to Fig. 2, a bi-directional transfer gate (2, 5, 6, or 9), as well known, is comprisedof p-channel and n-channel MOS (metal-oxide-semiconductor) transistors which are connected in parallel. The clock signal is applied to the gate of the p-channel MOS transistor and the inverted clock signal to the gate of the n-channel MOS transistor. Therefore, the bi-directional transfer gate is forced into a conduction state when the clock signal is at a low-voltage level (hereinafter referred to as L-level) and the inverted clock signal is at a high-voltage level (hereinafter referred to as H-level). Contrarily, the bi-directional transfer gate is forced into a high-impedance state when the clock signal is at H-level and the inverted clock signal is at L-level.

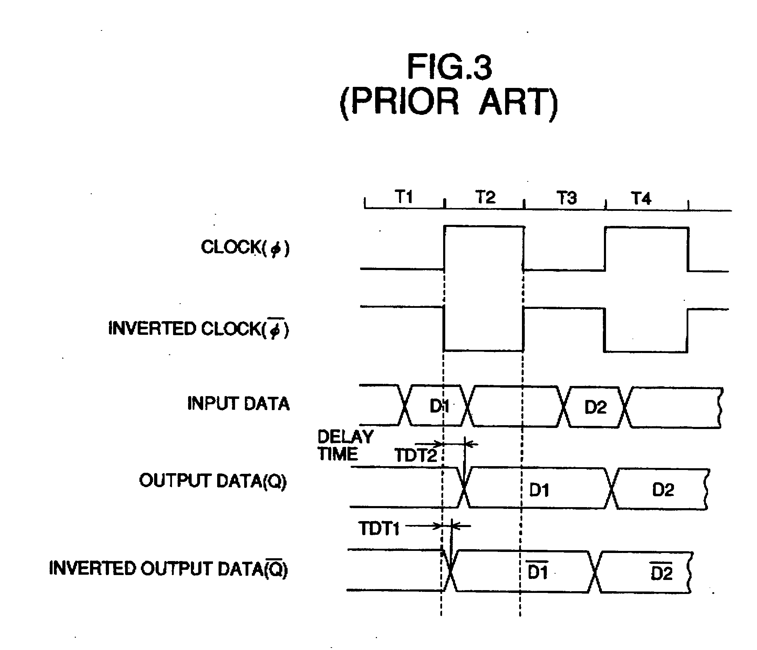

Referring to Fig. 3, in the time period T1 during which the clock signal is at L-level and the inverted clock signal is at H-level, input data D1 is fed into the master loop through the bi-directional transfer gate 2. Subsequently, in the time period T2 during which the clock signal is at H-level and the inverted clock signal is at L-level, the input data D1 is retained in the master loop. At the same time, the inverted data is fed into the slave loop through the bi-directional transfer gate 6, and the inverted data is applied to the inverted output terminal 10 and the data D1 is applied to the output terminal 11 through the inverter 7.

However, since the output of the bi-directional transfer gate 6 is transferred to the inverted output terminal 10 directly and to the output terminal 11 through the inverter 7, the transfer delay time TDT2 of the output data is longer than the transfer delay time TDT1 of the inverted output data by the delay time generated in the inverter 7. The transfer delay time period TDT1 is a time period from a predetermined level change of a pulse of the clock signal to the data appearance on the inverted output terminal. The transfer delay time period TDT2 is a time period from the predetermined level change of a pulse of the clock signal to the data appearance on the output terminal.

An object of the present invention is to provide a master-slave flip-flop circuit which achieves a high-speed flip-flop operation.

Another object of the present invention is to provide a circuit arrangement which rapidly changes in flip-flop states to produce retained data with reduced transfer delay time.

A circuit according to the present invention is comprised of a master loop and a slave loop, wherein the data and the inverted data retained in the master loop are respectively transferred to the output terminal and the inverted output terminal through the switching circuits each concurrently switching from a conduction state to a high-impedance state and vice versa.

According to an aspect of the present invention, a timing generator generates complementary clock signals according to an input clock signal, said complementary clock signals comprising a first clock signal and a second clock signal. The circuit is further comprised of a first loop and a second loop. The first loop holds input data according to the first clock signal to produce first data and second data on a first node and a second node, respectively. The first loop receives the input data at a first input node according to the second clock signal. The first data is complementary to the second data which is in phase with the input data. The second loop holds the first data according to the second clock signal and produces first output data and second output data on a first output node and a second output node, respectively. The second loop receives the first data at a second input node according to the first clock signal. The first output data is complementary to the second output data which is in phase with the first data.

The circuit is further comprised of a first switching circuit and a second switching circuit. The first switching circuit switches between a conduction state and a high-impedance state and electrically connects the first node of the first loop to the second input node as well as the second output node of the second loop according to the first clock signal. The second switching circuit switches between a conduction state and a high-impedance state and electrically connects the second node of the first loop to the first output node of the second loop according to the first clock signal.

The respective switching circuits are preferably formed with a transfer gate switching between a conduction state and a high-impedance state according to the first clock signal, especially a bi-directional transfer gate comprising CMOS transistors. Further preferably, the respective switching circuits are formed with a clocked inverter or a tristate inverter which switches between a conduction state and a high-impedance state according to the first clock signal.

Since the retained data of the master loop are transferred to the slave loop as well as the output terminal and the inverted output terminal, a reduced transfer delay time is achieved compared to the conventional circuit by about 25%, resulting in high-speed flip-flop operation.
Fig. 1 is a circuit diagram showing the circuit configuration of a conventional master-slave flip-flop circuit;
Fig. 2 is a circuit diagram showing a bi-directional transfer gate for use in a master-slave flip-flop circuit;
Fig. 3 is a timing chart showing a flip-flop operation of the conventional master-slave flip-flop circuit;
Fig. 4 is a circuit diagram showing the circuit configuration of a master-slave flip-flop circuit according to a first embodiment of the present invention;
Fig. 5 is a timing chart showing a flip-flop operation of the first embodiment;
Fig. 6 is a graph showing characteristics of transfer delay time with respect to data holding time;
Fig. 7 is a circuit diagram showing the circuit configuration of a master-slave flip-flop circuit according to a second embodiment of the present invention; and
Fig. 8 is a circuit diagram showing a clocked inverter for use in the second embodiment of Fig. 7.

### FIRST EMBODIMENT

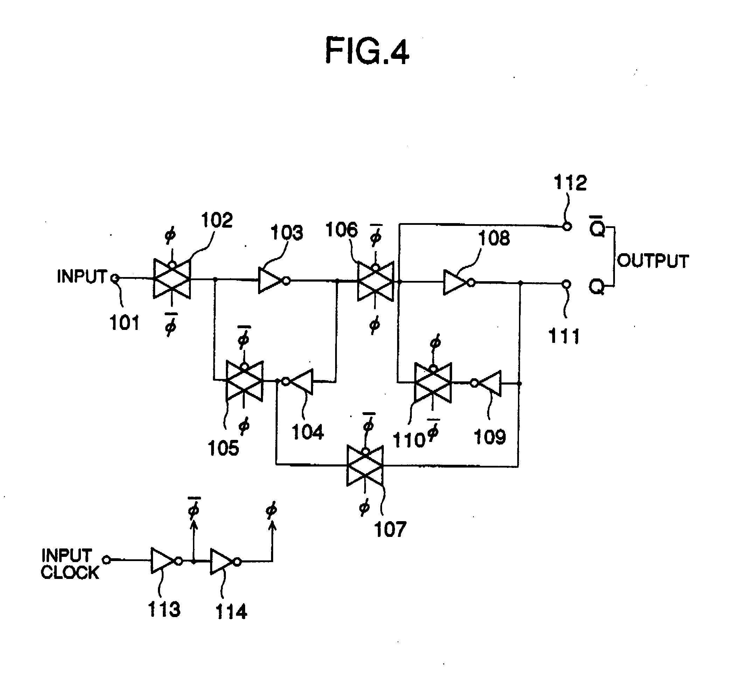

Referring to Fig. 4, a master-slave flip-flop circuit according to the first embodiment is comprised of a master loop and a slave loop. A data input terminal 101 is connected to the master loop through a bi-directional transfer gate 102. The master loop is comprised of an inverter 103, an inverter 104 and a bi-directional transfer gate 105 which are formed with a loop. The input of the inverter 103 is connected to the input terminal 101 through the bi-directional transfer gate 102 and the output of the inverter 103 is connected to the input of a bi-directional transfer gate 106. Furthermore, the output of the inverter 104 is connected to the input of a bi-directional transfer gate 107.

The slave loop is comprised of an inverter 108, an inverter 109 and a bi-directional transfer gate 110 which are formed with a loop. The input of the inverter 108 is connected to the output of the bi-directional transfer gate 106 and the input of the inverter 109 is connected to the output of the bi-directional transfer gate 107. The output of the inverter 108 is connected to a data output terminal 111 and the output of the bi-directional transfer gate 106 is connected to an inverted data output terminal 112.

The bi-directional transfer gates 102, 105, 106, 107 and 110 each have the same circuit arrangement as shown in Fig. 2. As described before, each gate switches between the conduction state and the high-impedance state according to the clock signal and the inverted clock signal. In this embodiment, the bi-directional transfer gates 102 and 110 perform the switching operation according to first clock timing and the bi-directional transfer gates 105, 106 and 107 perform the switching operation according to second clock timing. The first clock timing is inverted in phase to the second clock timing. The clock signal and the inverted clock signal are respectively generated through inverters 113 and 114 connected in series, and these clock signals are supplied to the bi-directional transfer gates 102, 105, 106, 107 and 110.

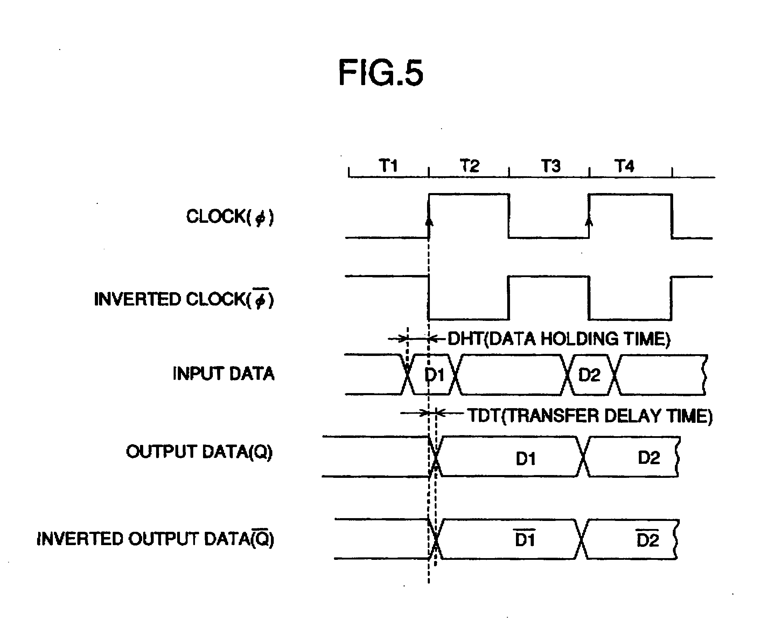

Referring to Fig. 5, the bi-directional transfer gate 102 is in the conduction state in the time period T1 during which the clock signal is at L-level and the inverted clock signal is at H-level. Therefore, input data D1 is fed into the master loop through the bi-directional transfer gate 102. Subsequently, when the clock signal rises from L-level to H-level, the bi-directional transfer gate 102 is forced into the high-impedance state, causing the master loop to be isolated from the input terminal 101. At the same time, the bi-directional transfer gates 105, 106, and 107 are forced into the conduction state. Therefore, in the time period T2 during which the clock signal is in H-level and the inverted clock signal is in L-level, the input data D1 is retained in the master loop and the inverted data is transferred from the inverter 103 to the slave loop as well as the inverted data output terminal 112 through the bi-directional transfer gate 106, and the data D1 is transferred from the inverter 104 to the data output terminal 111 through the bi-directional transfer gate 107.

Since the data D1 and the inverted data are transferred to the data output terminal 111 and the inverted data output terminal 112 through the bi-directional transfer gates 106 and 107, respectively, a transfer delay time period TDT of the data D1 and the inverted data is substantially equal to the delay time of one bi-directional transfer gate.

When the clock signal falls from H-level to L-level, the bi-directional transfer gates 105-107 are forced into the high-impedance state and the bi-directional transfer gates 102 and 110 into the conduction state. Therefore, the slave loop is isolated from the master loop, retaining the data D1 and the inverted data on the data output terminal 111 and the inverted data output terminal 112, respectively, until the transfer delay time TDT has elapsed after the clock signal rises from L-level to H-level again.

Compared to the conventional circuit as shown in Fig. 1, the embodiment has a shorter delay time TDT because of the bi-directional transfer gates 106 and 107 transferring the data D1 and the inverted data to the data output terminal 111 and the inverted data output terminal 112, respectively.

Comparison of delay characteristics is made between the conventional circuit and the embodiment. It is assumed that all the circuit elements are formed with a complementary-MOS logic circuit wherein a p-channel MOS transistor has a channel length of 0.35 micrometers and a channel width of 15.0 micrometers and an n-channel MOS transistor has a channel length of 0.35 micrometers and a channel width of 11.0 micrometers. Furthermore, both flip-flop circuits are driven under the same operation condition that the power supply voltage is 3.3V, the load capacitance 0.5pF, and the ambient temperature 25 degrees Celsius.

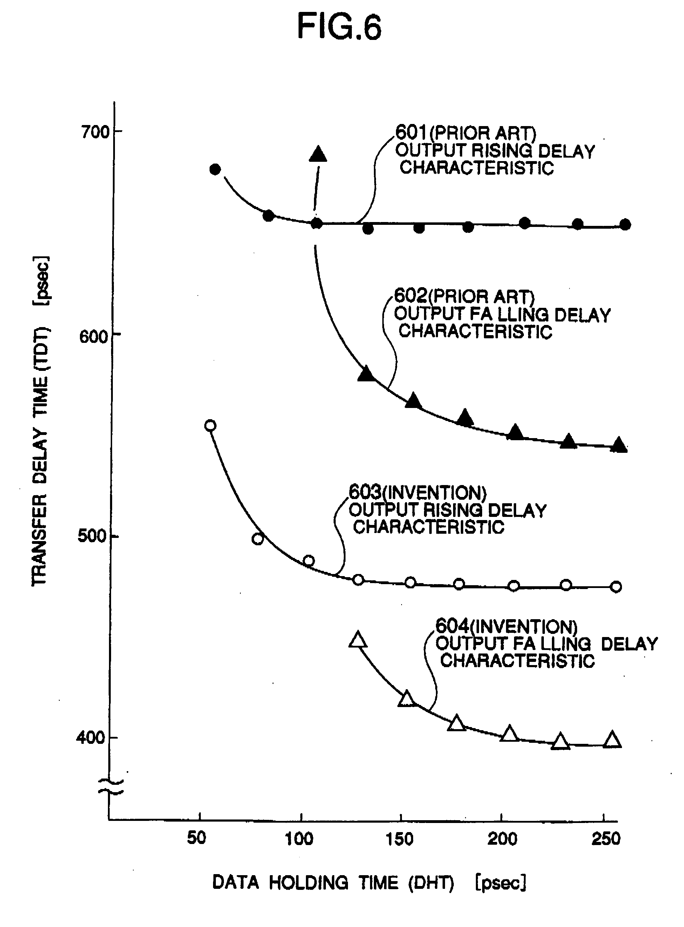

Referring to Fig. 6, the horizontal axis indicates a data holding time period starting from a time instant of data input and continuing until a clock pulse has risen to H-level (see Fig. 5), and the vertical axis indicates a transfer delay time period (TDT) required for data transfer to the data output terminal and the inverted data output terminal after a clock pulse has risen from L-level to H-level as described before. As shown in Fig. 6, the curves 601 and 602 represents the delay characteristics of the conventional flip-flop circuit as shown in Fig. 1 and the curves 603 and 604 represents the delay characteristics of the flip-flop circuit as shown in Fig. 4. The curve 601 indicates the output rising delay characteristic which is exhibited by the conventional flip-flop circuit when the data output terminal rises from L-level to H-level. The curve 602 indicates the output falling delay characteristic which is exhibited by the conventional flip-flop circuit when the data output terminal falls from H-level to L-level. Similarly, the curve 603 indicates the output rising delay characteristic which is exhibited by the flip-flop circuit of the embodiment when the data output terminal rises from L-level to H-level, and the curve 604 indicates the output falling delay characteristic which is exhibited by the embodiment when the data output terminal falls from H-level to L-level.

Generally, in order to secure the operation reliability of a master-slave flip-flop circuit, it is desired that the data output terminal rises to the power supply voltage or falls to the ground voltage according to the input data when a clock pulse rises from L-level to H-level. Referring to Fig. 6, such a condition is met in the regions of the curves 601-604 where the transfer delay time TDT changes little in respect to the data holding time DHT. Therefore, both the conventional flip-flop circuit and the embodiment necessitate a setup time period of about 200psec or more.

According to the curves 601 and 603 indicating the output rising delay characteristics, the transfer delay time TDT is 661psec for the conventional circuit and 479psec for the embodiment after a lapse of the setup time period. Similarly, according to the curves 602 and 604 indicating the output falling delay characteristics, the transfer delay time TDT is 555psec for the conventional circuit and 405psec for the embodiment after a lapse of the setup time period. Therefore, the embodiment has a shorter transfer delay time period TDT than the conventional circuit by about 25%, resulting in high-speed flip-flop operation.

### SECOND EMBODIMENT

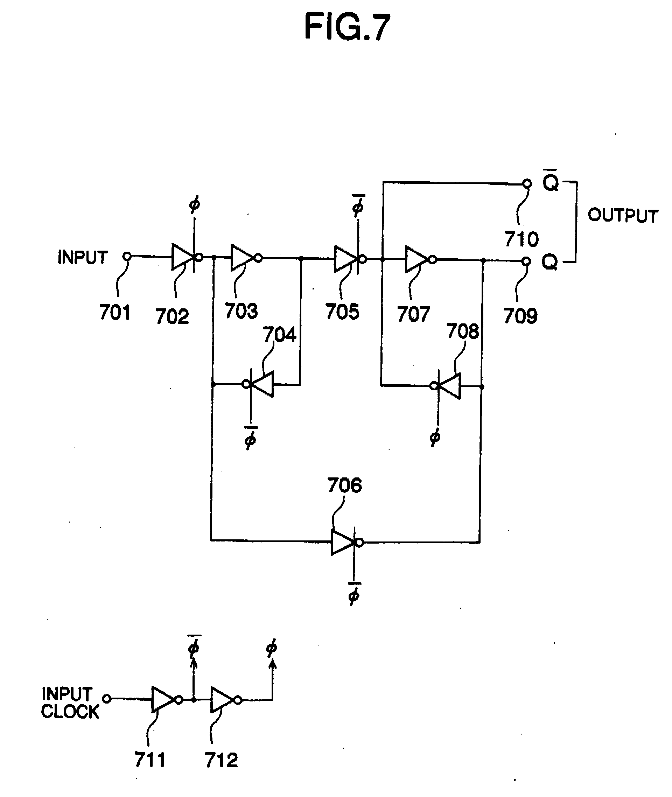

Referring to Fig. 7, a master-slave flip-flop circuit according to the second embodiment is comprised of inverters and clocked inverters (tristate inverters or switching inverters). More specifically, a data input terminal 701 is connected to a master loop through a clocked inverter 702. The master loop is comprised of an inverter 703 and a clocked inverter 704 which are formed with a loop. The input of the inverter 703 is connected to the input terminal 701 through the clocked inverter 702 and the output of the inverter 703 is connected to the input of a clocked inverter 705. Furthermore, the output of the clocked inverter 704 is connected to the input of a clocked inverter 706.

A slave loop is comprised of an inverter 707 and a clocked inverter 708 which are formed with a loop. The input of the inverter 707 is connected to the output of the clocked inverter 705 and the input of the clocked inverter 708 is connected to the output of the clocked inverter 706. The output of the inverter 707 is connected to a data output terminal 709 and the output of the clocked inverter 705 is connected to an inverted data output terminal 710.

The clocked inverters 702, 704, 705, 706, and 708 each have the same circuit arrangement as described later. Each clocked inverter switches between the conduction state and the high-impedance state according to a clock signal and an inverted clock signal. In this embodiment, the clocked inverters 702 and 708 perform the switching operation according to first clock timing and the clocked inverters 704-706 perform the switching operation according to second clock timing. The first clock timing is inverted in phase to the second clock timing. The clock signal and the inverted clock signal are respectively generated through inverters 711 and 712 connected in series. The clock signal is supplied to the clocked inverters 702 and 708, and the inverted clock signal is supplied to the clocked inverters 704, 705, and 706.

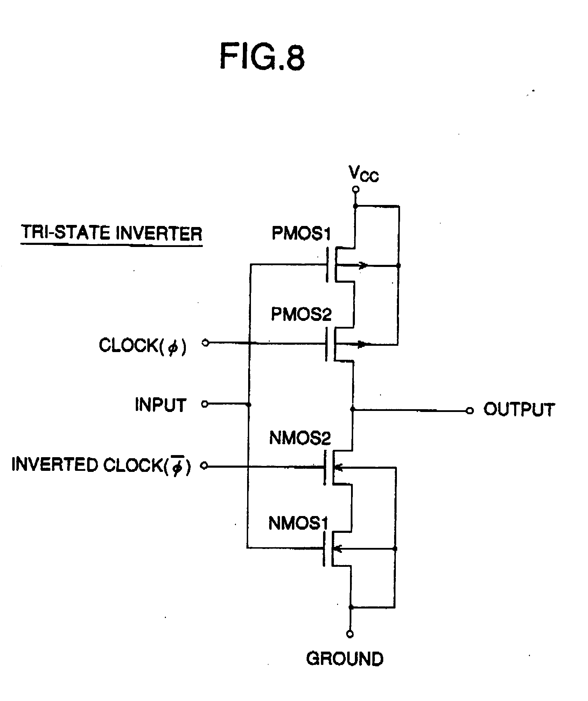

Referring to Fig. 8, a clocked inverter, a tri-state inverter, or a switching inverter is comprised of p-channel MOS transistors PMOS1, PMOS2 and n-channel MOS transistors NMOS1, NMOS2 which are connected in series, wherein the source electrode of the p-channel MOS transistor PMOS1 is connected to the power supply voltage vcc, and the source electrode of the n-channel MOS transistor NMOS1 is connected to the ground. The gate electrodes of the p-channel MOS transistor PMOS1 and the n-channel MOS transistor NMOS1 are connected in common to an input terminal. The drain electrodes of the p-channel MOS transistor PMOS2 and the n-channel MOS transistor NMOS2 are connected in common to an output terminal. The clock signal and the inverted clock signal are applied to the gate electrodes of the p-channel MOS transistor PMOS2 and the n-channel MOS transistor NMOS2, respectively.

In cases where the clock signal is in L-level and the inverted clock signal is in H-level, the p-channel MOS transistor PMOS2 and the n-channel MOS transistor NMOS2 both are in a conduction state. Therefore, when the input terminal is in L-level, the p-channel MOS transistor PMOS1 is in a conduction state and the n-channel MOS transistor NMOS1 in a high-impedance state, and thereby the output terminal becomes in H-level. When the input terminal is in H-level, the p-channel MOS transistor PMOS1 is in a high-impedance state and the n-channel MOS transistor NMOS1 in a conduction state, and thereby the output terminal becomes in L-level.

On the other hand, in cases where the clock signal is in H-level and the inverted clock signal is in L-level, the p-channel MOS transistor PMOS2 and the n-channel MOS transistor NMOS2 both are in a high-impedance state. Therefore, the output terminal is in a high-impedance state regardless of the voltage level of the input terminal.

The flip-flop operation of the second embodiment is described hereinafter referring to Figs. 5 and 7. The clocked inverter 702 is in the conduction state in the time period T1 during which the clock signal is at L-level and the inverted clock signal is at H-level. Therefore, input data is fed into the master loop through the clocked inverter 702. Subsequently, when the clock signal rises from L-level to H-level, the clocked inverter 702 is forced into the high-impedance state, causing the master loop to be isolated from the input terminal 101. At the same time, the clocked inverters 704 and 705 are forced into the conduction state. Therefore, in the time period T2 during which the clock signal is at H-level and the inverted clock signal is at L-level, the input data is retained in the master loop and the inverted data is transferred from the inverter 703 to the slave loop as well as the inverted data output terminal 710 through the clocked inverter 705, and the inverted data is transferred from the clocked inverter 704 to the clocked inverter 706 which in turn transfers the data to the data output terminal 709.

Since the data and the inverted data are transferred to the data output terminal 709 and the inverted data output terminal 710 through the tristate inverters 705 and 706, respectively, a transfer delay time period TDT of the data and the inverted data is substantially equal to the delay time of one clocked inverter.

When the clock signal falls from H-level to L-level, the clocked inverters 704-706 are forced into the high-impedance state and the clocked inverters 702 and 708 into the conduction state. Therefore, the slave loop is isolated from the master loop, retaining the data and the inverted data on the data output terminal 709 and the inverted data output terminal 710, respectively, until the transfer delay time TDT has elapsed after the clock signal rises from L-level to H-level again.

## Claims

1. A circuit comprising:
a timing generator (113, 114, 711, 712) for generating complementary clock signals according to an input clock signal, said complementary clock signals comprising a first clock signal and a second clock signal;
a first loop (103-105, 703-704) for holding input data according to said first clock signal to produce first data and second data on a first node and a second node, respectively, said first loop receiving said input data at a first input node according to said second clock signal, and said first data being complementary to said second data which is in phase with said input data; and
a second loop (108-110, 707-708) for holding said first data according to said second clock signal to produce first output data and second output data on a first output node and a second output node, respectively, said second loop receiving said first data at a second input node according to said first clock signal, and said first output data being complementary to said second output data which is in phase with said first data,
characterized by:
first switching means (106, 705) for switching between a conduction state and a high-impedance state, said first switching means electrically connecting said first node of said first loop to both said second input node and said second output node of said second loop according to said first clock signal; and
second switching means (107, 706) for switching between a conduction state and a high-impedance state, said second switching means electrically connecting said second node of said first loop to said first output node of said second loop according to said first clock signal.

2. The circuit according to claim 1, wherein:
said first switching means comprises a first transfer gate (106) switching between a conduction state and a high-impedance state according to said first clock signal; and
said second switching means comprises a second transfer gate (107) switching between a conduction state and a high-impedance state according to said first clock signal.

3. The circuit according to claim 2, wherein each of said first and second transfer gates comprises a bi-directional transfer gate.

4. The circuit according to claim 1, wherein:
said first switching means comprises a first clocked inverter (705) switching between a conduction state and a high-impedance state according to said first clock signal; and
said second switching means comprises a second clocked inverter (706) switching between a conduction state and a high-impedance state according to said first clock signal.

5. A circuit comprising:
a timing generator (113, 114) for generating complementary clock signals according to an input clock signal, said complementary clock signals comprising a first clock signal and a second clock signal;
a first switching loop for holding input data according to said first clock signal to produce first data and second data on a first node and a second node, respectively, said first loop receiving said input data at a first input node according to said second clock signal, and said first data being complementary to said second data which is in phase with said input data, said first switching loop comprising:
a first inverter (103) electrically connecting said first input node to said first node;
a second inverter (104) electrically connecting said first node to said second node; and
a first transfer gate (105) electrically connecting said second node to said first input node, for switching between a conduction state and a high-impedance state according to said first clock signal to produce said first data and said second data on said first node and said second node, respectively;
a second loop for holding said first data according to said second clock signal to produce first output data and second output data on a first output node and a second output node, respectively, said second loop receiving said first data at a second input node according to said first clock signal, and said first output data being complementary to said second output data which is in phase with said first data, said second loop comprising:
a third inverter (108) electrically connecting said second input node to said first output node;
a fourth inverter (109) electrically connecting said first output node; and
a second transfer gate (110) electrically connecting said fourth inverter to said second input node, for switching between a conduction state and a high-impedance state according to said first clock signal to produce said first output data and said second output data on said first output node and said second output node, respectively,
characterized by:
a third transfer gate (106) switching between a conduction state and a high-impedance state to electrically connect said first node of said first loop to both said second input node and said second output node of said second switching loop according to said first clock signal; and
a fourth transfer gate (107) switching between a conduction state and a high-impedance state to electrically connect said second node of said first loop to said first output node of said second loop according to said first clock signal.

6. The circuit according to claim 5, further comprising:
a fifth transfer gate (102) connected to said first input node of said first loop, for switching between a conduction state and a high-impedance state so as to transfer said input data to said first loop according to said second clock signal.

7. The circuit according to claim 6, wherein each of said first to fifth transfer gates comprises a bi-directional transfer gate.

8. The circuit according to claim 6, wherein:
each of said first to fifth transfer gates comprises a bi-directional transfer gate comprising CMOS (complementary metal-oxide-semiconductor) transistors; and
each of said first to fourth inverters comprises CMOS transistors.

9. A circuit comprising:
a timing generator (711, 712) for generating complementary clock signals according to an input clock signal, said complementary clock signals comprising a first clock signal and a second clock signal;
a first switching loop for holding input data according to said first clock signal to produce first data and second data on a first node and a second node, respectively, said first loop receiving said input data at said second node according to said second clock signal, and said first data being complementary to said second data which is in phase with said input data, said first switching loop comprising:
a first inverter (703) electrically connecting said second node to said first node; and
a first clocked inverter (704) electrically connecting said first node to said second node, for switching between a conduction state and a high-impedance state according to said first clock signal to produce said first data and said second data on said first node and said second node, respectively;
a second loop for holding said first data according to said second clock signal to produce first output data and second output data on a first output node and a second output node, respectively, said second loop receiving said first data at said second output node according to said first clock signal, and said first output data being complementary to said second output data which is in phase with said first data, said second loop comprising:
a second inverter (707) electrically connecting said second output node to said first output node;
a second clocked inverter (708) electrically connecting said first output node to said second output node, for switching between a conduction state and a high-impedance state according to said first clock signal to produce said first output data and said second output data on said first output node and said second output node, respectively,
characterized by:
a third clocked inverter (705) switching between a conduction state and a high-impedance state to electrically connect said first node of said first loop to said second output node of said second switching loop according to said first clock signal; and
a fourth clocked inverter (706) switching between a conduction state and a high-impedance state to electrically connect said second node of said first loop to said first output node of said second loop according to said first clock signal.

10. The circuit according to claim 9, further comprising:
a fifth clocked inverter (702) connected to said second node of said first loop, for switching between a conduction state and a high-impedance state so as to transfer said input data to said first loop according to said second clock signal.

11. The circuit according to claim 10, wherein each of said first to fifth clocked inverters comprises:
a first p-channel FET (field effect transistor) (P-MOST) for switching between a conduction state and a high-impedance state according to an input voltage, and said first p-channel FET having a first main electrode connected to a power supply voltage;
a second p-channel FET (P-MOS2) for switching between a conduction state and a high-impedance state according to said first clock signal, and said second p-channel FET having a first main electrode connected to a second main electrode of said first FET and having a second main electrode connected to a data output terminal;
a first n-channel FET (N-MOS2) for switching between a conduction state and a high-impedance state according to said second clock signal, and said first n-channel FET having a first main electrode connected to said data output terminal; and
a second n-channel FET (N-MOS1) for switching between a conduction state and a high-impedance state according to said input voltage, and said second n-channel FET having a first main electrode connected to a ground and having a second main electrode connected to a second electrode of said first n-channel FET.

12. The circuit according to claim 1, wherein said first loop and said second loop are a master loop and a slave loop of a flip-flop circuit, respectively.

13. A method for retaining input data into a first loop (103-105, 703-704) and a second loop (108-110, 707-708), comprising the steps of:
generating complementary clock signals according to an input clock signal, said complementary clock signals comprising a first clock signal and a second clock signal;
holding said input data at said first loop according to said first clock signal to produce first data and second data, said first loop receiving said input data according to said second clock signal, and said first data being complementary to said second data which is in phase with said input data; and
holding said first data at said second loop according to said second clock signal to produce first output data and second output data, said second loop receiving said first data according to said first clock signal, and said first output data being complementary to said second output data which is in phase with said first data,
characterized by the steps of:
switching between a conduction state and a high-impedance state to transfer said first data to said second loop and output said first data as said second output node of said second loop according to said first clock signal; and
switching between a conduction state and a high-impedance state to output said second data as said first output data of said second loop according to said first clock signal.
